**Europäisches Patentamt**

**European Patent Office**

**Office européen des brevets**

(19)

(11) Numéro de publication : **0 294 873 B1**

(12) **FASCICULE DE BREVET EUROPEEN**

(45) Date de publication du fascicule du brevet :
**07.09.94 Bulletin 94/36**

(51) Int. Cl.⁵ : **H01L 21/306,** G01N 21/55, G01B 11/06, H01L 21/66

(21) Numéro de dépôt : **88201095.2**

(22) Date de dépôt : **01.06.88**

(54) **Dispositif de test pour la mise en oeuvre d'un procédé de réalisaton de dispositifs semiconducteurs.**

(30) Priorité : **04.06.87 FR 8707796**

(43) Date de publication de la demande :
**14.12.88 Bulletin 88/50**

(45) Mention de la délivrance du brevet :
**07.09.94 Bulletin 94/36**

(84) Etats contractants désignés :
**DE FR GB IT NL**

(56) Documents cités :
**WO-A-83/04320**
**US-A- 4 317 698**
**JOURNAL OF THE ELECTROCHEMICAL SOCIETY, vol. 125, no. 5, mai 1978, pages 798-803; H.P. KLEINKNECHT et al.: "Optical monitoring of the etching of SiO2 andSi3N4 on Si by the use of grating test patterns"**

(73) Titulaire : **LABORATOIRES D'ELECTRONIQUE PHILIPS**
**3, Avenue Descartes**
**F-94450 Limeil-Brévannes (FR)**
(84) **FR**
Titulaire : **N.V. Philips' Gloeilampenfabrieken**
**Groenewoudseweg 1**
**NL-5621 BA Eindhoven (NL)**
(84) **DE GB IT NL**

(72) Inventeur : **Theeten, Jean-Bernard**
**Société Civile S.P.I.D.**
**209 rue de l'Université**
**F-75007 Paris (FR)**
Inventeur : **Autier, Philippe**
**Société Civile S.P.I.D.**
**209 rue de l'Université**
**F-75007 Paris (FR)**
Inventeur : **Auger, Jean-Marc**
**Société Civile S.P.I.D.**
**209 rue de l'Université**
**F-75007 Paris (FR)**

(74) Mandataire : **Landousy, Christian et al**
**Société Civile S.P.I.D.**
**156, Boulevard Haussmann**
**F-75008 Paris (FR)**

## Description

L'invention concerne un dispositif de test en combinaison avec un échantillon comprenant des moyens pour contrôler IN SITU les paramètres d'une gravure ionique réactive appliquée à la surface dudit échantillon dans une étape d'un procédé de réalisation de dispositifs semiconducteurs, ces moyens incluant :
- une source lumineuse incluant un faisceau laser de longueur d'onde $\lambda$ ;
- des moyens de détection de la lumière laser ($D_0$, $D_1$) ;
- ledit échantillon constitué d'un substrat en un premier matériau sur lequel est déposée une couche de masque en un second matériau, ladite couche de masque comprenant des ouvertures en forme de sillons de largeur $\ell_S$ espacés d'une largeur $\ell_M$ formant un réseau optique à profil rectangulaire, ce réseau étant disposé dans une région de la surface du substrat dépourvue de dispositifs semiconducteurs et étant éclairé sensiblement perpendiculairement par ledit faisceau laser.

Ce dispositif trouve son application dans le contrôle de la gravure ionique réactive de différentes couches qui intervient dans les procédés de réalisation de dispositifs semiconducteurs intégrés notamment sur arséniure de gallium (GaAs) ou phosphure d'indium (InP) et d'une façon générale sur des composés III-V.

L'invention concerne également un procédé de réalisation de dispositifs semiconducteurs mettant en oeuvre un tel dispositif de test en combinaison avec un échantillon.

Un dispositif de test pour la gravure ionique réactive est connu de la publication de H.P. KLEINKNECHT et H. MEIER dans Journal of Electrochemical Society Vol.125, N°5, Mai 1978, pages 798 à 803. Ce document décrit un dispositif de test comprenant un réseau optique formé sur l'un des échantillons de matériau semiconducteur destiné à être soumis à une gravure ionique réactive par plasma. Le réseau optique présente un profil rectangulaire. Il est composé d'ouvertures en forme de sillons pratiquées dans une couche de photorésist réalisée en surface d'une couche diélectrique de silice ($SiO_2$) ou de nitrure de silicium ($Si_3N_4$). Les sillons sont parallèles et régulièrement espacés. La couche de photorésist sert par ailleurs de masque pour réaliser, par gravure ionique réactive, la gravure de motifs dans la couche diélectrique, elle-même réalisée en surface d'un substrat semiconducteur de silicium (Si). Le dispositif de test est destiné au contrôle IN SITU de la profondeur de gravure de la couche diélectrique par gravure ionique réactive par plasma. A cet effet, le réseau optique est éclairé par un système comprenant un faisceau laser, de longueur d'onde 632,8 nm qui est modulé et dirigé sensiblement perpendiculairement sur le réseau optique placé dans le bâti de gravure ionique. Le contrôle est effectué par l'analyse de la lumière diffractée par le réseau. A cet effet l'intensité lumineuse provenant du réseau est recueillie par une diode photoélectrique.

Le contrôle de la gravure des couches diélectriques est obtenu par l'interprétation à l'aide de modèles de l'analyse quantitative des oscillations de l'intensité diffractée par le réseau. Afin d'obtenir les conditions de diffraction, la périodicité du réseau peut aller de 3 à 10,2 $\mu$m, cette dernière valeur étant préférée. L'ordre de diffraction 1 est uniquement étudié.

Le problème résolu par le dispositif de test selon le document cité est la détection de l'instant où la couche diélectrique est complètement gravée et le substrat semiconducteur mis à nu, dans le but d'éviter la gravure dudit substrat. Par mesure de l'intensité de diffraction, cet instant est connu par le fait qu'il coïncide avec une diminution brusque de l'intensité diffractée, qui se maintient ensuite à un niveau bas et constant.

Le document cité enseigne en outre que le contrôle de la gravure des couches diélectriques pourrait aussi être fait par la mesure de l'intensité de la réflexion spéculaire. Mais dans ce cas, le faisceau laser devrait être dirigé sur une région de la couche dépourvue de toute irrégularité sur une surface aussi large que le diamètre du faisceau laser, condition qui est en pratique difficile à réaliser dans l'élaboration de circuits intégrés sur substrats semiconducteurs. Notamment dans ce cas, un réseau optique ne pourrait être utilisé.

Une telle technique utilise la diffraction de la lumière. L'interprétation est simple dans le cas idéal d'un réseau pour lequel seule la profondeur des traits de gravure varie c'est-à-dire un modèle à 1 seul paramètre. La modélisation est très rapidement plus complexe dans les cas réalistes où l'ensemble de la géométrie du réseau se modifie au cours de l'attaque plasma. Plusieurs paramètres agissent sur l'intensité diffractée, dont les contributions sont pratiquement impossibles à séparer.

En particulier, il est impératif de pouvoir mesurer, non seulement l'épaisseur des couches diélectriques gravées, mais encore la profondeur gravée dans une ou plusieurs couches de matériau semiconducteur sous-jacent, ainsi que la rugosité des flancs de gravure, ou la rugosité du fond de l'ouverture gravée dans le ou les matériaux semiconducteurs.

Selon l'invention ces problèmes sont résolus au moyen d'un dispositif de test en combinaison avec un échantillon tel que defini dans la revendication 1. L'invention concerne également un procédé de réalisation de dispositifs semiconducteurs tel que revendiqué dans la revendication 6.

Pour atteindre ce but, un dispositif de test tel que décrit dans le préambule est caractérisé en ce que les largeurs $\ell_S$ et $\ell_M$ sont sensiblement égales entre elles et d'une dimension supérieure à la longueur de cohérence $\ell_C$ du faisceau laser pour permettre la réflexion spéculaire de la lumière de ce faisceau par le réseau en direction desdits moyens de détection.

Au moyen du dispositif de test selon l'invention, peuvent être obtenus entre autres les avantages suivants :

- le contrôle de la gravure ionique de trois matériaux peut être fait IN SITU, en continu, en parallèle avec la gravure.
- la commande des différents paramètres en jeu dans la gravure peut être subordonnée à ce contrôle.
- ce contrôle fournit en continu :
  . la valeur de la profondeur totale de gravure $d_G$ ;
  . la valeur de l'épaisseur enlevée à la couche supérieure du système gravé : $d'_M$ ;
  . l'épaisseur de la couche rugueuse sur les flancs d'un motif gravé : $\ell_F$ ;
  . l'épaisseur de la couche rugueuse dans le fond d'un motif gravé : $d_R$.
- le dispositif de test selon l'invention est facile à réaliser et plus facile à mettre en oeuvre que le dispositif de test selon l'art antérieur du fait que l'on est dispensé de moduler le faisceau laser servant de source. Il est également plus facile de réaliser des réseaux de 80 μm présentant des sillons larges de 40 μm espacés de 40 μm et sans précision spécifique, que des réseaux de périodicité de 10,2 μm présentant des sillons de 7 μm espacés de 3 μm.

L'invention sera mieux comprise au moyen de la description suivante illustrée par les figures annexées dont :

- les figures 1a et 1b qui montrent en coupe respectivement l'aspect d'un motif avant gravure et d'un motif après gravure ionique réactive ;
- la figure 2 qui montre schématiquement l'ensemble du dispositif de test selon l'invention ;
- la figure 3a qui montre en coupe schématique le réseau optique inclus dans le dispositif de test selon l'invention et la figure 3b qui montre ce réseau vu du dessus ;
- la figure 4 qui montre en coupe le trajet des rayons du faisceau laser incidents et réfléchis par le réseau ;
- la figure 5a qui montre la courbe d'intensité lumineuse réfléchie par le réseau en fonction du temps de gravure, lorsque le réseau est réalisé sur un substrat d'arséniure de gallium ;
- la figure 5b qui montre la courbe d'intensité lumineuse réfléchie par le réseau en fonction du temps de gravure, lorsque le réseau est réalisé dans une couche de nitrure de silicium ($Si_3N_4$) en surface d'une couche mince d'arséniure de gallium et d'aluminium déposée sur un substrat d'arséniure de gallium.

Lors de la réalisation de circuits intégrés sur des substrats semiconducteurs, est souvent mise en oeuvre une une étape de gravure d'un matériau par une méthode dite gravure ionique réactive (R.I.E. de l'anglais = Reactive Ion Etching).

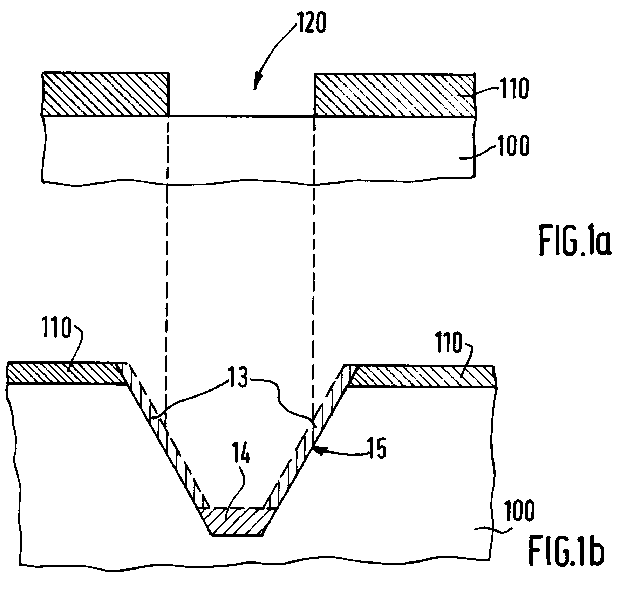

Les figures 1a et 1b illustrent cette méthode. Sur un matériau 100 à graver considéré comme substrat, est déposée une couche 110 pour former un masque. Des ouvertures ou fenêtres 120 sont pratiquées dans le masque 110 par exemple par photolithographie aux emplacements choisis pour la gravure du substrat 100. La figure 1a montre ce dispositif en coupe schématique avant gravure ionique réactive.

La figure 1b montre schématiquement selon une coupe correspondant à la figure 1a, l'aspect de l'ouverture 14, 15 obtenue après gravure du substrat 100 dans le prolongement de l'ouverture 120.

La couche formant masque 110 peut être un film mince d'un matériau organique ou d'un métal ou d'un composé diélectrique tel que la silice ($SiO_2$) ou le nitrure de silicium ($Si_3N_4$).

Le matériau à graver ou substrat 100 peut être un autre composé diélectrique ou un composé semiconducteur choisi parmi les composés du groupe IV ou du groupe III-V ou du groupe II-VI. Si par exemple le masque est en silice, le matériau à graver peut être le nitrure de silicium ou vice versa. Les matériaux semiconducteurs peuvent être le silicium, l'arséniure de gallium, l'arséniure de gallium et d'aluminium, le phosphure d'indium, cités à titre d'exemples non limitatifs.

Lors de la mise en oeuvre de l'étape d'attaque par plasma, le comportement idéal serait que la couche mince 110 qui sert de masque soit laissée intacte et que uniquement le substrat soit gravé, dans les fenêtres 120, en maintenant la figure géométrique révélée par photolithographie, c'est-à-dire avec des flancs d'attaque verticaux aux limites masque/fenêtre. En pratique, trois phénomènes parasites apparaissent :

1) la surface 14 du substrat 100 devient rugueuse au cours de l'attaque ;

2) les flancs d'attaque 15 sont rugueux et non verticaux, c'est-à-dire qu'on développe une rugosité latérale 13 ;

3) le masque 110 lui-même est attaqué et son épaisseur diminue au cours de la gravure plasma.

Selon l'invention, ces trois phénomènes parasites pourront être minimisés. En effet, comme ils varient de manière complexe en fonction des paramètres microscopiques du plasma (géométrie des électrodes du plasma, pression dans la chambre plasma, nature et pression partielle des gaz de gravure, température de l'échantillon, nature du masque utilisé...), l'optimisation est très difficile et longue si on ne dispose pas de moyens de caractérisation rapides et précis. La présente invention permet d'apporter entres autres une solution à ce problème au moyen du dispositif de test décrit ci-après.

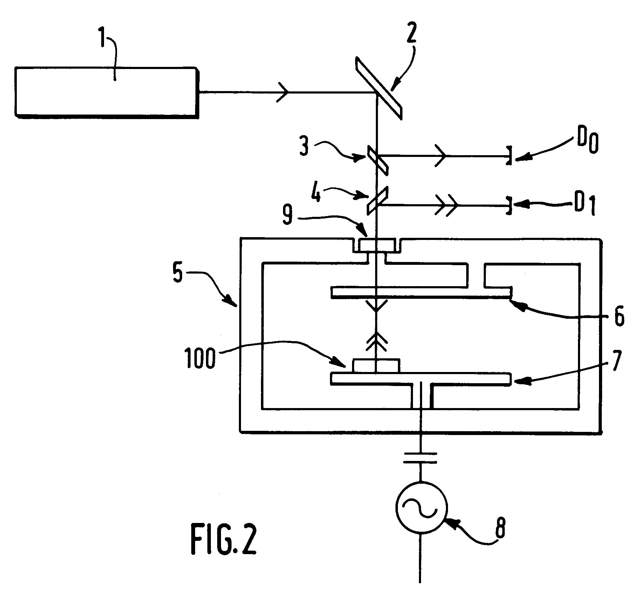

La figure 2 illustre schématiquement le dispositif de test selon l'invention appliqué à la mise en oeuvre d'une méthode de gravure ionique réactive.

Un échantillon 100 de matériau à graver est disposé dans une enceinte 5 sur la cathode 7, face à l'anode 6, entre lesquelles s'établit, grâce à l'alimentation 8, un flux de plasma, l'enceinte étant en outre munie d'arrivées non représentée pour des gaz tels que $CHF_3$ ou $CF_4$ choisis en fonction du ou des matériaux à graver.

L'enceinte 5 est munie d'une fenêtre 9, sur laquelle est dirigé par la réflexion sur le miroir 2, le faisceau d'un laser 1. Entre le miroir 2 et la fenêtre 9, le faisceau directement issu du laser est partiellement réfléchi par une lame semi-réfléchissante 3 en direction d'un moyen de détection $D_0$ qui peut être avantageusement une diode photo-électrique au silicium, afin de fournir un signal de référence de l'intensité incidence.

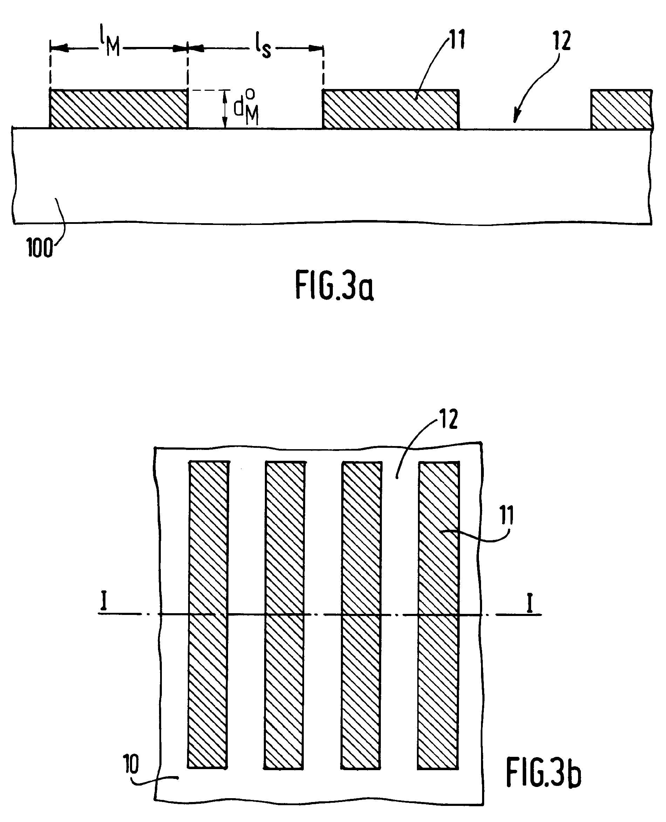

Le faisceau émis par le laser est dirigé vers l'échantillon 100 perpendiculairement à sa surface. La plage de l'échantillon qui est éclairée par le faisceau laser a été préalablement munie d'un réseau optique tel que décrit plus loin, en référence avec les figures 3a et 3b. Ce réseau optique est prévu pour permettre, non pas la diffraction comme connu de l'art antérieur, mais la réflexion spéculaire du faisceau laser. La lumière réfléchie par le réseau optique est envoyée à travers la fenêtre 9 au moyen d'une lame semiréfléchissante 4 sur une diode photoélectrique $D_1$ pour fournir un signal de détection de l'intensité réfléchie par le réseau.

Le faisceau laser et les moyens de détection de l'intensité réfléchie sont appliqués à l'enceinte 5 pendant toute la durée de l'opération de gravure ionique réactive.

La figure 3a représente une coupe schématique selon l'axe I-I de la figure 3b du réseau du dispositif de test selon l'invention.

Ce réseau est réalisé en surface de la couche ou du matériau massif, dit substrat 100 à graver. Il est disposé dans une région du substrat dépourvue de dispositifs semiconducteurs en cours d'élaboration.

Ce réseau est formé par des ouvertures en forme de sillon 12 pratiquées dans une couche d'un matériau 11, qui peut être avantageusement l'un des matériaux précédemment cités comme appropriés à constituer un masque.

Comme il est montré sur la figure 3a le profil du réseau est rectangulaire. Les sillons ont une largeur $\ell_S$ et sont espacés par des bandes de la couche 11 dites bandes de masque qui ont une largeur $\ell_M$. Un tel réseau peut être réalisé par une méthode connue en soi de photolithographie.

La figure 3b montre une partie du réseau vue du dessus. Les sillons sont parallèles et régulièrement espacés.

Avantageusement, le réseau couvrira sur le substrat une surface de 1mm x 1mm.

Dans le but de permettre la réflexion spéculaire du faisceau laser, qui est à la base des avantages procurés par l'invention, les largeurs $\ell_S$ et $\ell_M$ seront choisies sensiblement égales entre elles et égales à 40 µm, pour se trouver notablement plus grandes que la valeur de la longueur de cohérence $\ell_C$ du faisceau laser dont la longueur d'onde $\lambda$ est choisie de 628,3 nm, ce qui est obtenu au moyen d'un laser He-Ne.

La longueur de cohérence est définie comme étant la distance à l'intérieur de laquelle deux points sont toujours suffisamment proches pour interférer.

La longueur de cohérence du faisceau laser est alors une constante du système optique et est :
$$\ell_C \simeq 20 \ \mu m$$
Une méthode de détermination de la valeur de la longueur de cohérence d'un tel système optique sera exposée plus loin en détail.

Ainsi, des régions du réseau séparées de plus de 20 µm renvoient des faisceaux de lumière sans cohérence de phase entre eux et dont les intensités s'ajoutent et non plus les amplitudes comme selon l'art antérieur. Cette propriété permet de découpler les contributions respectives des divers mécanismes évoqués ci-dessus :

1) vitesse de gravure du substrat ($v_S$),
2) vitesse de gravure du masque ($v_M$),
3) rugosité latérale ($r_L$),
4) rugosité du substrat ($r_S$).

Le choix de $\ell_S = \ell_M \simeq 40$ µm est un compromis qui s'appuie sur le fait que :

1) cette valeur de $\ell_S$ et $\ell_M$ est alors plus grande que la longueur de cohérence du laser pour permettre des contributions séparées des bandes de masque 11 et des sillons 12 ;

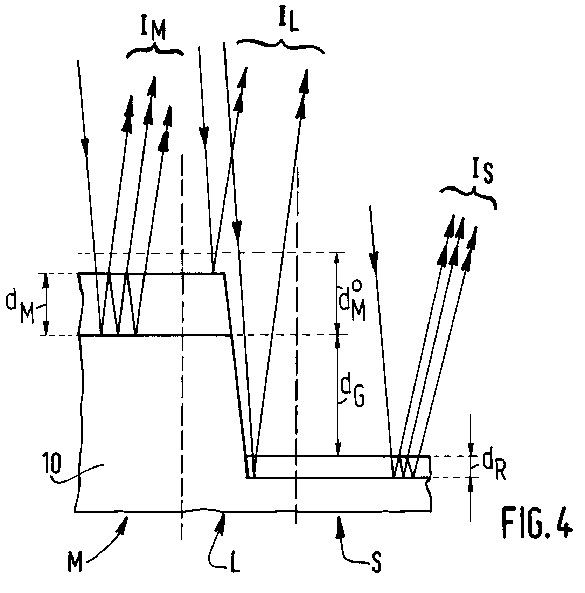

2) cette valeur de $\ell_S$ et $\ell_M$ est néanmoins assez faible pour que les régions aux limites bande/sillon donnent encore une contribution significative au signal global de réflexion. L'intérêt d'un tel motif de réseau se voit lorsqu'on examine une situation typique en cours de gravure, comme représentée sur la figure 4.

On peut distinguer sur cette figure 4 trois types de région qui contribuent à la réflexion spéculaire du faisceau laser.

Les régions M de bande de masque 11 situées à plus d'une dimension de cohérence d'une limite bande de masque/sillon qui correspondent aux interférences multiples dans le film mince d'épaisseur $d_M^o$ qui constitue les bandes 11 avant gravure. Pour une incidence du laser normale à la surface, l'amplitude réfléchie par une région M est donnée par la relation :

$$A_M = \frac{r_{AM} + r_{MS} . \exp(-j\phi_M)}{1 + r_{AM} . r_{MS} . \exp(-j\phi_M)}$$

où $r_{AM}$ est le coefficient de Fresnel à l'interface air-bande de masque

$r_{MS}$ est le coefficient de Fresnel à l'interface bande de masque-substrat

$$\phi_M = 2 \times \frac{2\pi}{\lambda} . n_M . d_M$$

où $n_M$ est indice optique du matériau de la bande de masque à la longueur d'onde $\lambda$ du laser et $d_M$ est l'épaisseur de cette bande de masque en cours de gravure.

De même, les régions S du substrat, situées à plus d'une longueur de cohérence d'une limite bande/sillon, correspondent aux interférences multiples dans le film mince d'épaisseur $d_R$ de rugosité du substrat développée au cours de l'attaque plasma. L'amplitude réfléchie par ces régions est donnée par la relation :

$$A_S = \frac{r_{AR} + r_{RS} . \exp(-j\phi_R)}{1 + r_{AR} . r_{RS} . \exp(-j\phi_R)}$$

où $r_{AR}$ est le coefficient de Fresnel à l'interface air-rugosité

$r_{RS}$ est le coefficient de Fresnel à l'interface rugosité-substrat

$$\phi_R = 2 \times \frac{2\pi}{\lambda} . n_R . d_R$$

où $n_R$ est indice optique du film de rugosité et où $d_R$ est l'épaisseur de la couche rugueuse.

Enfin, les régions L situées aux limites bande de masque/sillon et de largeur $\ell_C$ égale à la longueur de cohérence de la lumière laser, correspondent aux interférences entre le haut et le bas des motifs en cours de gravure. Si $d_G$ représente l'épaisseur gravée dans le substrat, c'est-à-dire la différence de hauteur entre l'interface substrat/bande et l'interface air/rugosité du substrat, la contribution en amplitude réfléchie de ces régions L est donnée par la relation :

$$A_L = A_M + A_S . \exp(-j\phi_G)$$

avec

$$\phi_G = 2 \times \frac{2\pi}{\lambda} . d_G$$

Il est essentiel de noter, du fait de l'incidence normale de la lumière laser, que les flancs verticaux ou non, du motif à la limite bande/sillon, ne contribuent pas à l'amplitude réfléchie spéculairement. Au cours de la gravure, ces flancs occupent une largeur $\ell_F$ et les régions L ont donc une contribution proportionelle à $\ell_c - \ell_F$.

Les proportions respectives des trois types de région M,S et L sont donc :

$$\ell'_M, \ell'_S \text{ et } 2\,\ell_c$$

avec

$$\ell'_M + \ell'_S + 2\,\ell_c = \ell_M + \ell_S$$

et

$$\ell'_M = \ell'_S$$

Au cours de la gravure, l'intensité globale réfléchie est donc donnée par la relation :

$$I = \frac{\ell'_M . |A_M|^2 + \ell'_S . |A_S|^2 + 2(\ell_C - \ell_F) . |A_L|^2}{\ell_M + \ell_S}$$

où les quantités variant au cours d'une attaque plasma sont donc, par ordre d'importance décroissante
- l'épaisseur gravée $d_G$ agissant sur $A_L$
- l'épaisseur résiduelle du masque $d_M$ agissant sur $A_M$ et $A_L$
- la dimension latérale $\ell_F$ des flancs de gravure
- la rugosité du substrat $d_R$ agissant sur $A_S$ et $A_L$.

L'intérêt de notre invention est que les contributions de ces 4 quantités sont séparables et qu'on peut obtenir leurs 4 valeurs à partir de la seule mesure au cours du temps de l'intensité de la réflexion spéculaire.

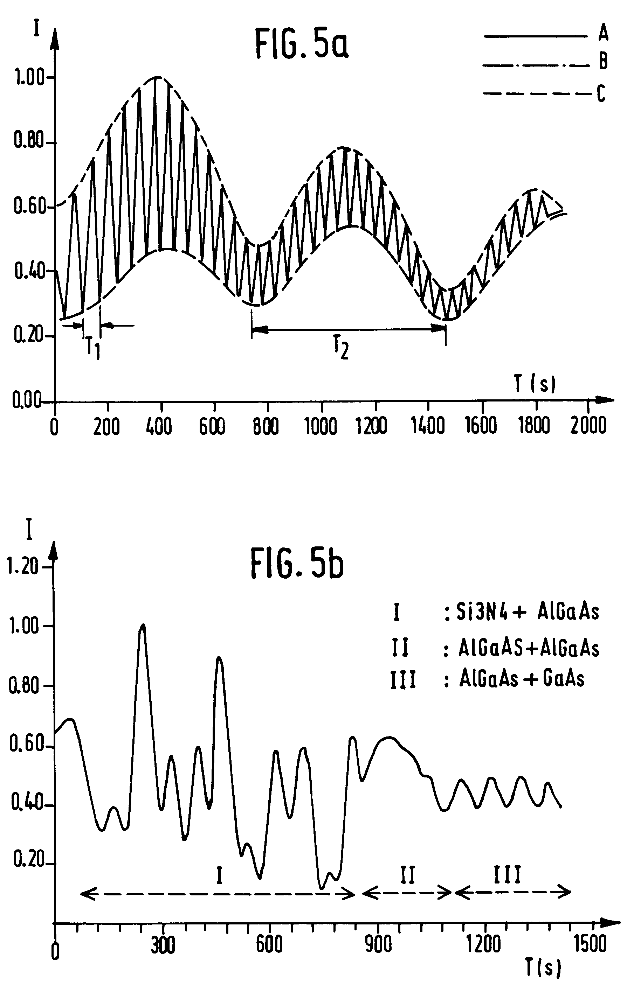

Une utilisation typique de cette méthode est maintenant décrite, qui correspond à la mesure de l'intensité de réflexion spéculaire, donnée dans la figure 5a. Il s'agit d'une gravure ionique réactive d'un substrat de GaAs orienté (100) dans un ensemble commercial (bâti NEXTRAL NE 110 C). Les conditions expérimentales étaient les suivantes :
- pression totale $\simeq$ 0,4 Pa (3m Torr)
- puissance RF = 70W (tension d'autopolarisation 250 V)
- pressions partielles de gaz
  $Cl_2 = 4.5$
  $CH_4 = 4.5$
  $Ar = 9$

La figure 5a montre que l'intensité réfléchie I varie au cours du temps t, selon une allure de sinusoïde de courte période $T_1$ (entre 2 minima) illustrée par la courbe A, en traits pleins. L'amplitude de la courbe A est en outre décroissante. Cette courbe admet deux enveloppes : l'enveloppe B des minima qui est une si-nusoïde à période $T_2$ longue par rapport à $T_1$ ($T_2$ étant pris entre 2 minima) et l'enveloppe C des maxima qui est aussi une sinusoïde de période $T_2$ mais dont l'am-plitude est décroissante.

La période courte $T_1$ correspond dans le terme $A_L$ à la variation de $d_G$. Chaque période de temps $T_1$ correspond à une profondeur de gravure :

$$P_1 = \lambda/2n_o = \lambda/2$$

où $n_o$ est l'indice de l'air ($n_o = 1$).

Si la gravure ionique commence au temps $t_o$, au bout d'un temps $t_1$ sera gravée une profondeur

$$d_G = N_1P_1 + (n_M - n_0)(d^o_M - d_M) \text{ où } P_1 = N_1 \lambda/2,$$
$$n_0 = 1$$

et où $N_1$ est le nombre de périodes $T_1$ qui apparais-sent entre le temps $t_o$ et le temps $t_1$.

Ainsi l'évaluation de la profondeur gravée peut être faite en permanence pendant toute la durée de l'opération de gravure.

Dans l'exemple cité où $\lambda$ = 632,8 nm
$T_1$ correspond à $P_1 \simeq$ 316 nm de matériau gravé.

La période longue $T_2$ correspond à la profondeur $P_2$ gravée en superficie des bandes de masque du ré-

seau

$$P_2 = \lambda/2n_M$$

où $n_M$ est l'indice du matériau des bandes du réseau. Si les bandes du réseau sont en silice (SiO$_2$) d'indice

$$n \simeq 1,53$$

$T_2$ correspond à $P_2 = 205$ nm de silice gravée.

Au bout d'un temps $t_1$, la gravure aura diminué l'épaisseur des bandes de masque du réseau d'une valeur $(n_M - n_0)(d_M^o - d_M) = N_2 P_2$ où $P_2 = \lambda/2 n_M$, $n_0 = 1$. et où $N_2$ est le nombre de périodes $T_2$ qui apparaissent entre le temps $t_o$ et le temps $t_1$.

L'épaisseur de substrat 100, réellement gravée sera donnée par $d_G = (N_1 \lambda/2) + (N_2 \lambda/2n_M)$

$$d_G = N_1 P_1 + N_2 P_2$$

La diminution de l'amplitude de la sinusoïde A de courte période est due uniquement à la rugosité latérale $\ell_F$. La figure 5a montre que $\ell_F$ atteint pratiquement $\ell_C$ au bout d'un temps $t = 2000$ s. (c'est à dire une amplitude nulle de la contribution $(\ell_C - \ell_F) |A_L|^2$). Or, pour un échantillon témoin sacrifié soumis à une telle gravure, la rugosité mesurée au microscope électronique à balayage est

$$\ell_F \simeq 20 \ \mu m$$

ce qui nous permet de déduire que la valeur de la longueur de cohérence $\ell_C$ du système optique selon l'invention est $\ell_c = 20 \ \mu m$.

A tout instant t, la dimension latérale $\ell_F$ des flancs de gravure peut alors être déduite des courbes de la figure 5a. En effet la valeur $\ell_F$-$\ell_C$ est proportionnelle à la différence des amplitudes entre la courbe B et la courbe C. Ce qui peut s'ecrire :

$$\ell_F - \ell_C = K \cdot \Delta A$$

La constante de proportionnalité K est determinée par modélisation en tenant compte du fait que lorsque la différence des amplitudes $\Delta A$ est maximale, la dimension $\ell_F$ est minimale ou nulle ($\ell_F \simeq 0$)

Enfin la rugosité $d_R$ du fond du sillon après gravure à un instant t peut être donnée par la modélisation de la décroissance de l'intensité minimale de la courbe B (enveloppe inférieure), modélisation qui tient compte du fait que la rugosité peut être simulée par une couche d'indice de réfraction effectif compris entre celui de l'air et celui du substrat. Cette modélisation peut être faite en mesurant l'épaisseur de rugosité $d_R$ d'un ou plusieurs échantillons de référence. Cette mesure peut être réalisée par éllipsométrie spectroscopique, méthode connue des demandes EP-A-267634 et EP-A-266814.

On pourra noter que la courbe B de la figure 5a ne montre pas de décroissance considérable, ce qui resulte du fait que les conditions de gravure sont bonnes et qu'il n'apparaît alors qu'une extrêmement faible rugosité au fond du sillon. Ici l'épaisseur de rugosité dR au fond des sillons a été estimée à 10 nm.

La figure 5b montre la courbe d'intensité réfléchie par un réseau dont les bandes sont en nitrure de silicium (Si$_3$N$_4$) réalisées sur un substrat constitué d'une couche mince d'arséniure de gallium et aluminium (GaAlAs) réalisée en surface d'arséniure de gallium (GaAs). Un simple examen des ruptures de pente de la courbe I en fonction du temps permet de dectecter :

- la fin de la gravure de Si$_3$N$_4$
- la fin de la gravure de AlGaAs dans les sillons.

La gravure ionique réactive des couches diélectriques a été réalisée à l'aide de gaz CHF$_3$ ou CF$_4$ et la gravure ionique réactive des composés semiconducteurs à l'aide des gaz Cl$_2$, CH$_4$, Ar.

La région I de la figure 5b correspond à la gravure de Si$_3$N$_4$ et AlGaAs.

La région II correspond à la gravure de AlGaAs seule et la région III à la gravure de AlGaAs et GaAs.

L'avantage de la méthode selon l'invention est donc la détermination directe en temps réel des 4 paramètres $d_G$, $d_M$, $\ell_F$ et $d_R$. La technique classique en ce domaine qui était jusqu'à présent connue de l'état de la technique, était l'examen a posteriori au microscope électonique à balayage de sections clivées de l'échantillon. Outre les caractères destructifs et longs de cette méthode, elle présente l'inconvénient de ne donner que l'état final après gravure, sans pouvoir accéder à la dynamique des phénomènes. Au contraire, la méthode selon l'invention :

- fournit en temps réel les évolutions de $d_G$, $d_M$, $\ell_F$ et $d_R$ ;
- permet de trier rapidement les mauvaises conditions de fonctionnement (en particulier les cas où $d_R$ et $\ell_F$ sont forts)
- est interprétable par lecture directe de l'évolution de I en fonction du temps t dans le cas où $d_M \ll d_G$ ;
- est bien adaptée à la situation complexe où le "substrat" est constitué de plusieurs couches minces successives.

## Revendications

1. Dispositif de test en combinaison avec un échantillon comprenant des moyens pour contrôler IN SITU les paramètres d'une gravure ionique réactive (RIE) appliquée à la surface dudit échantillon dans une étape d'un procédé de réalisation de dispositifs semiconducteurs, ces moyens incluant :

- une source lumineuse (1) incluant un faisceau laser de longueur d'onde $\lambda$ ;
- des moyens de détection de la lumière laser ($D_0$, $D_1$) ;
- ledit échantillon constitué d'un substrat (100) en un premier matériau sur lequel est déposée une couche de masque (11) en un second matériau, ladite couche de masque comprenant des ouvertures (12) en forme de sillons de largeur $\ell_S$ espacés d'une lar-

geur $\ell_M$ formant un réseau optique à profil rectangulaire, ce réseau étant disposé dans une région de la surface du substrat dépourvue de dispositifs semiconducteurs et étant éclairé sensiblement perpendiculairement par ledit faisceau laser, caractérisé en ce que les largeurs $\ell_S$ et $\ell_M$ sont sensiblement égales entre elles et d'une dimension supérieure à la longueur de cohérence $\ell_C$ du faisceau laser pour permettre la réflexion spéculaire de la lumière de ce faisceau par le réseau en direction desdits moyens de détection.

2. Dispositif de test caractérisé en ce que les moyens de contrôle incluent en outre des moyens d'enregistrement des variations de l'intensité spéculaire réfléchie par le réseau durant toute l'étape de gravure ionique réactive, des moyens de calcul des paramètres de gravure en fonction de ces variations et des moyens de commande de la durée de gravure en fonction de ces paramètres.

3. Dispositif de test selon la revendication 2, caractérisé en ce que le faisceau laser a une longueur d'onde de 632,8 nm et en ce que les dimensions $\ell_S$ et $\ell_M$ respectivement des sillons et des espacements du réseau sont sensiblement égales à 40 $\mu m$.

4. Dispositif de test selon l'une des revendications 2 ou 3, caractérisé en ce que le premier matériau ou substrat dont la gravure ionique doit être contrôlée est un composé semiconducteur du groupe III-V et le second matériau est un diélectrique.

5. Dispositif de test selon la revendication 4, caractérisé en ce que le premier matériau ou substrat dont la gravure ionique doit être contrôlée est choisi parmi l'arséniure de gallium (GaAs), l'arséniure de gallium et d'aluminium (GaAlAs), le phosphure d'indium (InP), et ce que la couche dans laquelle est gravé le réseau est choisie parmi la silice (SiO$_2$) ou le nitrure de silicium (Si$_3$N$_4$).

6. Procédé de réalisation de dispositifs semiconducteurs, incluant au moins une étape de gravure ionique réactive mettant en oeuvre le dispositif de test selon l'une des revendications 1 à 5, et selon lequel le substrat (100) est gravé durant cette étape de gravure à travers les ouvertures de la couche de masque (11) formant le réseau optique, et la profondeur totale $d_G$ gravée dans le substrat (100) est contrôlée, en ce que le réseau optique est éclairé par le faisceau laser de longueur d'onde $\lambda$ et la variation de l'intensité spéculaire réfléchie fournie en retour par le réseau est enregistrée, la courbe d'intensité réfléchie relevée consistant en une première courbe périodique (A) d'amplitude décroissance de période courte $T_1$, et en deux enveloppes périodiques (B,C) de cette première courbe, l'enveloppe des maxima ou enveloppe supérieure étant une courbe périodique d'amplitude décroissante et de période longue $T_2$, et l'enveloppe des minima ou enveloppe inférieure étant également une courbe périodique de période longue $T_2$, la profondeur totale $d_G$ gravée dans le substrat (100) étant donnée par la relation :

$$d_G = N_1 \cdot P_1 + N_2 \cdot P_2$$ entre un instant $t_o$ et un instant $t_1$

où

$N_1$ est le nombre de périodes courtes entre $t_o$ et $t_1$

$$P_1 = \lambda / 2 n_o$$

$n_o$ est l'indice de réfraction de l'air et où $N_2$ est le nombre de périodes longues $T_2$ entre $t_o$ et $t_1$

$$P_2 = \lambda / 2\, n_M$$ et

$n_M$ est l'indice de la couche (11) constituant le réseau.

7. Procédé selon la revendication 6, caractérisé en ce que la courbe d'intensité réfléchie fournit également les paramètres de gravure qui sont :
- la dimension latérale $\ell_F$ des flancs de gravure donnée par $\ell_F - \ell_C = K \times$ différence des amplitudes à un instant t entre les deux courbes enveloppes, la constante K étant déterminée par une modélisation qui tient compte du fait que :

$\ell_F = 0$ lorsque la différence des amplitudes est maximale

et

$\ell_F = \ell_C$ lorsque la différence des amplitudes est nulle;
- l'épaisseur $d_R$ de la rugosité au fond du sillon gravé, calculée à un instant t à partir d'une modélisation de la décroissance de l'intensité minimale de la courbe enveloppe inférieure, modélisation qui tient compte du fait que la rugosité peut être simulée par une couche d'indice de réfraction effectif compris entre celui de l'air et celui du substrat.

8. Procédé selon la revendication 7, caractérisé en ce que pour déterminer la dimension latérale $\ell_F$ des flancs de gravure à un instant donné t à partir des courbes, ce procédé inclut une calibration qui est faite en mesurant au microscope électronique à balayage, la dimension latérale $\ell_F$ des flancs d'un échantillon de référence réalisé dans les conditions où $\ell_F = \ell_C$, permettant de connaître $\ell_C$

qui est une constante du faisceau laser.

9. Procédé de réalisation selon l'une des revendications 7 ou 8, caractérisé en ce qu'il inclut une modélisation pour la détermination de l'épaisseur $d_R$ de rugosité au fond du sillon gravé qui est faite en mesurant par ellipsométrie spectroscopique l'épaisseur de rugosité $d_R$ d'un échantillon de référence.

**Patentansprüche**

1. Testvorrichtung in Kombination mit einer Probe, wobei die Testvorrichtung Mittel umfaßt, um in situ die Parameter einer während eines Schrittes eines Verfahrens zur Herstellung von Halbleiteranordnungen auf der Oberfläche dieser Probe durchgeführten reaktiven Ionenätzung (RIE) zu kontrollieren, wobei diese Mittel
   - eine Lichtquelle (1) mit einem Laserstrahlenbündel der Wellenlänge $\lambda$ und
   - Mittel zur Detektierung des Laserlichtes ($D_0$, $D_1$) umfassen,
   - sowie die aus einem ersten Substrat (100) aus einem ersten Material bestehende Probe, auf dem eine Maskenschicht (11) aus einem zweiten Material aufgebracht ist, wobei die genannte Maskenschicht Öffnungen (12) in Form von Rillen mit einer Breite $\ell_S$ und einem gegenseitigen Abstand $\ell_M$ umfaßt, die ein optisches Gitter mit Rechteckprofil bilden, und wobei dieses Gitter sich in einem Gebiet der Oberfläche des Substrats befindet, in der sich keine Halbleiteranordnungen befinden und die im wesentlichen senkrecht von dem genannten Laserstrahlenbündel beleuchtet wird, <u>dadurch gekennzeichnet</u>, daß die Breiten $\ell_S$ und $\ell_M$ einander im wesentlichen gleich und von einer größeren Abmessung als die Kohärenzlänge $\ell_C$ des Laserstrahlenbündels sind, um die gerichtete Reflexion des Lichtes dieses Bündels vom Gitter in Richtung der genannten Detektionsmittel zu ermöglichen.

2. Testvorrichtung, <u>dadurch gekennzeichnet</u>, daß die Kontrollmittel außerdem Mittel umfassen zur Registrierung der Veränderungen der durch das Gitter gerichtet reflektierten Intensität während der gesamten Verlaufs des reaktiven Ionenätzens, Mittel zur Berechnung der Ätzparameter in Abhängigkeit von diesen Veränderungen und Mittel zur Steuerung der Ätzdauer in Abhängigkeit von diesen Parametern.

3. Testvorrichtung nach Anspruch 2, <u>dadurch gekennzeichnet</u>, daß das Laserstrahlenbündel eine Wellenlänge von 632,8 nm hat und daß die Abmessungen $\ell_S$ und $\ell_M$ der Rillen beziehungsweise der Zwischenräume des Gitters im wesentlichen gleich 40 µm sind.

4. Testvorrichtung nach einem der Ansprüche 2 oder 3, <u>dadurch gekennzeichnet</u>, daß das erste Material oder Substrat, dessen Ionenätzung kontrolliert werden soll, eine Halbleiterverbindung aus der Gruppe III-V ist und das zweite Material ein Dielektrikum ist.

5. Testvorrichtung nach Anspruch 4, <u>dadurch gekennzeichnet</u>, daß für das erste Material oder Substrat, dessen Ionenätzung kontrolliert werden soll, Galliumarsenid (GaAs), Galliumaluminiumarsenid (GaAlAs) oder Indiumphosphid (InP) gewählt wird, und für die Schicht, in die das Gitter geätzt wird, Siliziumdioxid ($SiO_2$) oder Siliziumnitrid ($Si_3N_4$) gewählt wird.

6. Verfahren zur Herstellung von Halbleiteranordnungen mit mindestens einem reaktiven Ionenätzschritt unter Verwendung der Testvorrichtung nach einem der Ansprüche 1 bis 5, wobei das Substrat (100) während dieses Ätzschrittes durch die Öffnungen in der das optische Gitter bildendenden Maskenschicht (11) geätzt wird und die Gesamtätztiefe $d_G$ im Substrat (100) kontrolliert wird, und das optische Gitter von dem Laserstrahlenbündel mit der Wellenlänge $\lambda$ belichtet wird und die Veränderung der durch das Gitter zurückgeworfenen gerichtet reflektierten Intensität registriert wird, wobei die erhaltene Kurve der reflektierten Intensität aus einer ersten periodischen Kurve (A) mit abnehmender Amplitude mit kurzer Periode $T_1$ und aus zwei periodischen Hüllkurven (B, C) dieser ersten Kurve besteht, wobei die Hüllkurve der Maxima oder obere Hüllkurve eine periodische Kurve mit abnehmender Amplitude mit langer Periode $T_2$ ist und die Hüllkurve der Minima oder untere Hüllkurve ebenfalls eine periodische Kurve mit langer Periode $T_2$ ist, wobei die Gesamtätztiefe $d_G$ im Substrat (100) gegeben ist durch die Beziehung

$$d_G = N_1 \cdot P_1 + N_2 \cdot P_2$$ zwischen einem Zeitpunkt $t_0$ und einem Zeitpunkt $t_1$, wobei $N_1$ die Anzahl der kurzen Perioden zwischen $t_0$ und $t_1$ ist,
$P_1 = \psi/2n_0$ ist,
$n_0$ die Brechzahl von Luft ist
und wobei $N_2$ die Anzahl der langen Perioden $T_2$ zwischen $t_0$ und $t_1$ ist,
$P_2 = \psi/2n_M$ ist und
$n_M$ der Index der das Gitter bildenden Schicht (11) ist.

7. Verfahren nach Anspruch 6, <u>dadurch gekennzeichnet</u>, daß die Kurve der reflektierten Intensität ebenfalls die folgenden Parameter liefert:

- die laterale Abmessung $\ell_f$ der Ätzkanten, gegeben durch $\ell_F$-$\ell_C$ = K mal Amplituden-unterschied zwischen den beiden Hüllkur-ven zu einem Zeitpunkt t, wobei die Konstante K durch die Aufstellung eines Modells bestimmt werden kann, das berück-sichtigt, daß

$\ell_F$ = 0, wenn der Amplitudenunter-schied maximal ist und

$\ell_F$ = $\ell_C$, wenn der Amplitudenunter-schied null ist;

- die Dicke $d_R$ der Rauheit am Boden der geätzten Rille, berechnet zu einem Zeitpunkt t und ausgehend von der Aufstellung eines Modells für die Abnahme der minimalen Intensität der unteren Hüllkurve, wobei in diesem Modell berücksichtigt wird, daß die Rauheit durch eine Schicht mit einer effektiven Brechzahl, die zwischen der der Luft und der des Substrates liegt, simuliert werden kann.

8. Verfahren nach Anspruch 7, <u>dadurch gekenn-zeichnet</u>, daß zur Bestimmung der lateralen Ab-messung $\ell_F$ der Ätzkanten zu einem gegebenen Zeitpunkt t anhand der Kurven dieses Verfahren eine Kalibrierung einschließt, bei der unter einem Rasterelektronenmikroskop die laterale Abmes-sung $\ell_F$ der Kanten einer unter den Bedingungen $\ell_F$ = $\ell_C$ verwirklichten Bezugsprobe gemessen wird, wodurch $\ell_C$, eine Konstante des Laserstrahlenbündels, ermittelt werden kann.

9. Herstellungsverfahren nach einem der Ansprü-che 7 oder 8, <u>dadurch gekennzeichnet</u>, daß es die Aufstellung eines Modells für die Bestimmung der Dicke $d_R$ der Rauheit am Boden der geätzten Rille umfaßt, indem mit Hilfe spektroskopischer Ellipsometrie bei einer Bezugsprobe die Dicke $d_R$ der Rauheit gemessen wird.

## Claims

1. A testing device in combination with a sample comprising means for controlling *in situ* the parameters of a reactive ion etching (RIE) process applied to the surface of said sample in a step in a manufacturing process of semiconductor devices, which means include:

- a light source (1) including a laser beam with wavelength $\lambda$;
- detection means for the laser light ($D_0$, $D_1$);
- said sample being formed by a substrate (100) of a first material on which is deposited a masking layer of a second material, said masking layer (11) comprising openings (12) in the form of grooves with a width $\ell_S$ interspaced by a width $\ell_M$ forming an opt-ical grating of rectangular profile, which grating is arranged in a region of the substrate surface devoid of semiconductor de-vices and illuminated substantially perpen-dicularly by said laser beam, characterized in that the widths $\ell_S$ and $\ell_M$ are mutually substantially equal and have a dimension greater than the coherence zone $\ell_C$ of the laser beam so as to facilitate the specular reflection of the light of this beam by the grating in the direction of said detection means.

2. A testing device, characterized in that the control means in addition comprise registration means for the variations in specular reflection intensity by the grating throughout the reactive ion etching step, calculation means for the etching parameters as a function of these variations, and actuation means for adjusting the duration of the etching step as a function of these parameters.

3. A testing device as claimed in Claim 2, characterized in that the laser beam has a wavelength of 632.8 nm and in that the dimensions $\ell_S$ and $\ell_M$ of the grooves and the interspacings, respectively, of the grating are substantially equal to 40 $\mu$m.

4. A testing device as claimed in one of the Claims 2 and 3, characterized in that the first material or substrate of which the ion etching is to be controlled is a semiconductor compound from the group III-V, and the second material is a dielectric.

5. A testing device as claimed in Claim 4, characterized in that the first material or substrate of which the ion etching is to be controlled is chosen from among gallium arsenide (GaAs), gallium-aluminium arsenide (GaAlAs), indium phosphide (InP), and in that the layer into which the grating is etched is chosen from among silicon oxide ($SiO_2$) and silicon nitride ($Si_3N_4$).

6. A method of manufacturing semiconductor devices, comprising at least a reactive ion etching step in which the testing device as claimed in any one of the Claims 1 to 5 is used, and in which the substrate (100) is etched during this etching step through the openings in the masking layer (11) which forms the optical grating, and the total depth $d_G$ etched into the substrate (100) is monitored, characterized in that the optical grating is illuminated by the laser beam of wavelength $\lambda$ and the variation in intensity of the specular reflection returned by the grating is registered, the reflected intensity curve obtained consisting of a first periodic curve (A) of decreasing amplitude with a short period $T_1$, and of periodic envelopes (B, C) of this first curve, the envelope of the maxima or upper envelope being a periodic curve of decreasing amplitude and with a long period $T_2$, and the envelope of the minima or lower envelope also being a periodic curve with the long period $T_2$, while the total depth $d_G$ etched into the substrate (100) is given by the relation:

$d_G = N_1.P_1 + N_2.P_2$ between a moment $t_0$ and a moment $t_1$

where $N_1$ is the number of short periods between $t_0$ and $t_1$

$P_1 = \lambda/2n_0$

$n_0$ being the refractive index of air

and $n_2$ the number of long periods $T_2$ between $t_0$ and

$t_1$

$P_2 = \lambda/2n_M$ and

$n_M$ being the refractive index of the layer (11) which forms the grating.

7. A method as claimed in Claim 6, characterized in that the reflected intensity curve at the same time provides the etching parameters, which are:

- the lateral dimension $\ell_F$ of the etching edges given by $\ell_F - \ell_C = K \times$ the difference in amplitude between the two enveloping curves at a moment t, the constant K being determined by a modelling operation which takes into account the fact that:

$\ell_F = 0$ when the amplitude difference is a maximum, and

$\ell_F = \ell_C$ when the amplitude difference is zero;

- the thickness $d_R$ of the roughness at the bottom of the etched groove, calculated at a moment t on the basis of modelling of the decrease in the minimum intensity of the lower envelope, which modelling takes into account the fact that the roughness may be simulated by a layer with an effective refractive index which lies between that of air and that of the substrate.

8. A method as claimed in Claim 7, characterized in that, for determining the lateral dimension $\ell_F$ of the etching edges at a given moment t on the basis of the curves, said method comprises a calibration which is carried out by measurement with a scanning electron microscope, the lateral dimension $\ell_F$ of the edges of a reference sample realised under conditions in which $\ell_F = \ell_C$ rendering possible the recognition of $\ell_C$ which is a constant of the laser beam.

9. A manufacturing method as claimed in Claim 7 or 8, characterized in that it comprises a modelling operation for determining the thickness $d_R$ of the roughness at the bottom of the etched groove, which is achieved through measurement of the roughness thickness $d_R$ of a reference sample by spectroscopic ellipsometry.

120

110

100

FIG.1a

110

110

13

14

15

100

FIG.1b

FIG.2

$l_M$

$l_S$

11

12

$d_M^0$

100

## FIG.3a

12

11

I      I

10

## FIG.3b

FIG.4

FIG.5a

FIG.5b

I : Si3N4 + AlGaAs

II : AlGaAS + AlGaAs

III : AlGaAs + GaAs